# EUROPEAN PATENT APPLICATION

(11) **EP 4 679 956 A1**
(43) Date of publication of application: **14.01.2026**
(21) Application number: 25184309.0
(22) Date of filing: 20.06.2025
(51) Int. Cl.: H05K 7/20

(54) **AUTOMATIC FLOW REGULATION FOR COOLING SYSTEMS**

(30) Priority: 08.07.2024 US 202463668707 P
(71) Applicant: Vertiv Corporation, Westerville, OH 43082 (US)
(72) Inventor: Bissaro, Carlo, Westerville, 43082 (US); Parise, Andrea, Westerville, 43082 (US); Barbato, Pierpaolo, Westerville, 43082 (US)
(74) Representative: Cousens, Nico

(57) **Abstract**

A cooling system for direct-to-chip cooling can include a cold manifold for distributing a cooling fluid within an enclosure, a warm manifold for receiving the cooling fluid from within the enclosure, a cold fluid line fluidically coupled between the cold manifold and a cold plate thermally coupled to a processor, a warm fluid line fluidically coupled between the warm manifold and the cold plate, and a flow regulator to regulate flow through the warm fluid line based at least in part on a temperature of the cooling fluid flowing through the warm fluid line. The cooling system can include a cold fluid line, a cold plate, a warm fluid line, and a flow regulator for each processor. The cooling system can include a pump that maintains a differential pressure between the cold manifold and the warm manifold independently of a flow rate through individual regulators.

## Description

### CROSS REFERENCE TO RELATED APPLICATIONS

This application claims the benefit of U.S. Provisional Patent Application No. 63/668,707 filed July 8, 2024.

### TECHNICAL FIELD

The present disclosure relates generally to cooling systems and more specifically relates to flow regulation for direct-to-chip cooling systems, such as those using single-phase cooling.

### BACKGROUND

Cooling Distribution Units (CDUs) are often installed in data centers that deliver coolant to rack servers. Coolant is distributed over servers via standard manifolds to split the flow and reach the chips inside each server enclosure to cool down their surfaces. Direct-to-chip, single-phase systems are often based on CDUs that deliver coolant at a certain flowrate and temperature to the cold plates. Knowing the peak heat load and maximum chip temperature, both the flowrate and supply temperature from CDUs can be defined and kept constant.

However, since heat load can vary over time, holding flow rate constant often means that the system is providing more flowrate than necessary, resulting in over-cooling of idle chips and energy waste, such as wasted pump energy. Since a single CDU can feed a variety of different cold plates, with different hydraulic characteristics and installation losses, maldistribution can also arise.

### SUMMARY

Applicant has created new and useful devices, systems and methods for flow regulation for direct-to-chip cooling systems, such as those utilizing single-phase cooling to cool processors in data center enclosures. In at least one embodiment, maintaining a constant, or near constant, differential pressure across the system and allowing independent flow regulators to regulate flow through each direct-to-chip cold plate, based on temperature, allows for increased efficiencies. For instance, embodiments of the disclosure can reduce power consumption by automatically accounting for individual processor usage without requiring complex control systems. As other examples, embodiments of the disclosure can provide for self-balancing across a plurality of cold plates independently from thermal load value and distribution, improved system reactivity and power consumption via sensors for maintaining pressure differentials across manifolds rather than across the whole system, minimizing effective flow rates in any load condition, maximizing free cooling, improved heat recovery sources via constant return temperatures, or any combination thereof.

In at least one embodiment, a cooling system according to the disclosure can be arranged for cooling heat-producing equipment within a cabinet or other enclosure, such as those used in data centers for housing computer-related equipment. In at least one embodiment, the cooling system can include a cold manifold for distributing a cooling fluid within the enclosure, a warm manifold for collecting or receiving the cooling fluid from within the enclosure, a cold fluid line fluidically coupled between the cold manifold and a cold plate thermally coupled to a processor, a warm fluid line fluidically coupled between the warm manifold and the cold plate, a flow regulator for regulating flow through the warm fluid line based at least in part on a temperature of the cooling fluid flowing through the warm fluid line, or a combination thereof. In at least one embodiment, the cold manifold can receive the cooling fluid, such as a water/glycol mixture, from outside the enclosure, such as from a cooling distribution unit (CDU) which can include, or be associated with, a pump and/or a heat exchanger.

In at least one embodiment, the flow regulator can be fluidically coupled between the warm manifold and the cold plate, such as in-line with the warm fluid line. In at least one embodiment, the flow regulator can regulate flow through the first warm fluid line based at least in part on the cooling fluid flowing through the flow regulator. In at least one embodiment, the flow regulator can regulate flow through the warm fluid line based at least in part on a temperature of the cooling fluid flowing through the flow regulator.

In at least one embodiment, the flow regulator can regulate flow independently of pressure. In at least one embodiment, the flow regulator can regulate flow using an internal temperature sensor, such as a mechanical temperature sensing element that does not need electrical power and/or electronic control. In at least one embodiment, the flow regulator can maintain a non-zero minimum flow rate through the warm fluid line, monitor the temperature of the processor, and increase flow through the cold plate as the processor begins to warm up and heat the cooling fluid flowing through the cold plate, the warm fluid line, the flow regulator, or any combination thereof.

In at least one embodiment, the system can include a pump to pump the cooling fluid to the cold manifold from the warm manifold, such as through a heat exchanger. In at least one embodiment, the pump can pump the cooling fluid to the cold manifold from the warm manifold maintaining a predetermined differential pressure between the cold manifold and the warm manifold. In at least one embodiment, the system can include a first pressure sensor for monitoring a first pressure of the cold manifold and a second pressure sensor for monitoring a second pressure of the warm manifold. In at least one embodiment, the pump can pump the cooling fluid to the cold manifold from the warm manifold based at least in part on a difference between the first pressure and the second pressure. In at least one embodiment, the pump can pump the cooling fluid to the cold manifold from the warm manifold based on a difference between the first pressure and the second pressure independently of flow through the warm fluid line and/or the temperature of the cooling fluid flowing through the warm fluid line.

In at least one embodiment, the system can include a second cold fluid line fluidically coupled between the cold manifold and a second cold plate thermally coupled to a second processor, a second warm fluid line fluidically coupled between the warm manifold and the second cold plate, a second flow regulator for regulating flow through the second warm fluid line based at least in part on a second temperature of the cooling fluid flowing through the second warm fluid line, or any combination thereof. In at least one embodiment, the second flow regulator can be fluidically coupled between the warm manifold and the second cold plate, such as in-line with the second warm fluid line. In at least one embodiment, the second flow regulator can regulate flow through the second warm fluid line based on the second temperature as sensed within the second flow regulator. In at least one embodiment, the second flow regulator can be identical to the first flow regulator. In at least one embodiment, the second flow regulator can regulate flow through the second warm fluid line independently of the first flow regulator. In at least one embodiment, the pump can maintain the predetermined differential pressure independently of the flow through the first warm fluid line and/or independently of the flow through the second warm fluid line.

In at least one embodiment, the cooling system, such as for a data center equipment enclosure, can include a cold manifold for receiving cold cooling fluid from outside the enclosure and distributing the cooling fluid within the enclosure, a first pressure sensor for monitoring a first pressure of the cold manifold, a warm manifold for collecting or receiving the cooling fluid from within the enclosure, a second pressure sensor for monitoring a second pressure of the warm manifold, a first cold fluid line fluidically coupled between the cold manifold and a first cold plate thermally coupled to a first processor, a first warm fluid line fluidically coupled between the warm manifold and the first cold plate, a first flow regulator for regulating flow through the first warm fluid line based on a first temperature of the cooling fluid flowing through the first flow regulator, a second cold fluid line fluidically coupled between the cold manifold and a second cold plate thermally coupled to a second processor, a second warm fluid line fluidically coupled between the warm manifold and the second cold plate, a second flow regulator for regulating flow through the second warm fluid line based on a second temperature of the cooling fluid flowing through the second flow regulator, a pump to pump the cooling fluid to the cold manifold from the warm manifold based on a difference between the first pressure and the second pressure, or any combination thereof.

In at least one embodiment, the first pressure sensor can be fluidically coupled to the cold manifold and/or the second pressure sensor can be fluidically coupled to the warm manifold. In at least one embodiment, the first flow regulator can be fluidically coupled between the warm manifold and the first cold plate, such as in-line with the first warm fluid line. In at least one embodiment, the second flow regulator can be fluidically coupled between the warm manifold and the second cold plate, such as in-line with the second warm fluid line. In at least one embodiment, the pump can pump the cooling fluid to the cold manifold from the warm manifold through a heat exchanger.

### BRIEF DESCRIPTION OF THE DRAWINGS

FIG. 1 is a simplified diagram of one of many embodiments of a cooling system according to the disclosure.
FIG. 2 is a simplified diagram of another one of many embodiments of a cooling system according to the disclosure.
FIG. 3 is a simplified diagram of yet another one of many embodiments of a cooling system according to the disclosure.
FIG. 4 is a simplified diagram of a portion of one of many embodiments of a cooling system according to the disclosure.
FIG. 5 is a schematic diagram of one of many embodiments of a cooling system according to the disclosure.
FIG. 6 is a graph illustrating reduced flow and resulting power requirements according to one of many embodiments of a cooling system according to the disclosure.
FIG. 7 is a graph illustrating reduced differential pressure requirements according to one of many embodiments of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the disclosure and subject matter of the claims. Those skilled in the art will appreciate that not all features of an embodiment of the disclosure are described or shown for the sake of clarity and understanding. Persons of skill in this art will also appreciate that the development of an actual commercial embodiment incorporating aspects of the present disclosure will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the disclosure taught herein is susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the disclosure or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for flow regulation for direct-to-chip cooling systems, such as those utilizing single-phase cooling to cool processors in data center enclosures. In at least one embodiment, maintaining a constant, or near constant, differential pressure across the system and allowing independent flow regulators to regulate flow through each direct-to-chip cold plate, based on temperature, allows for increased efficiencies. For instance, embodiments of the disclosure can reduce power consumption by automatically accounting for individual processor usage without requiring complex control systems. As other examples, embodiments of the disclosure can provide for self-balancing across a plurality of cold plates independently from thermal load value and distribution, improved system reactivity and power consumption via sensors for maintaining pressure differentials across manifolds rather than across the whole system, minimizing effective flow rates in any load condition, maximizing free cooling, improved heat recovery sources via constant return temperatures, or any combination thereof.

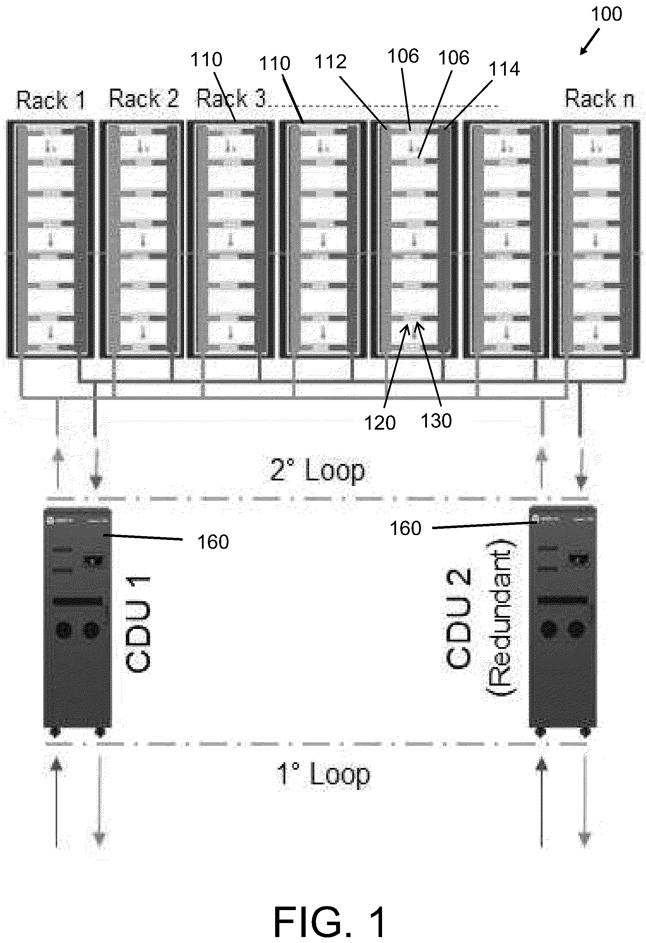

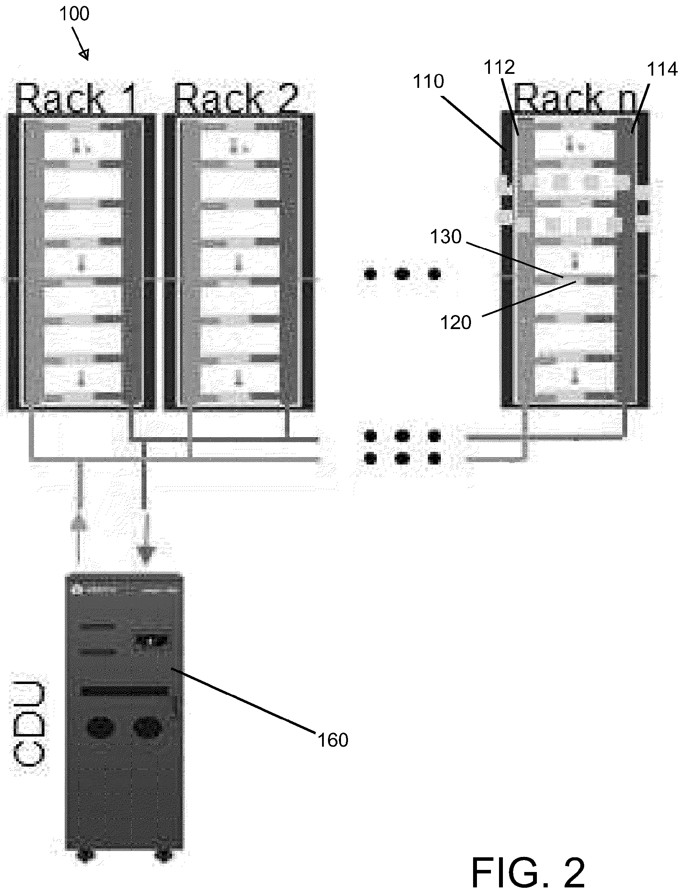

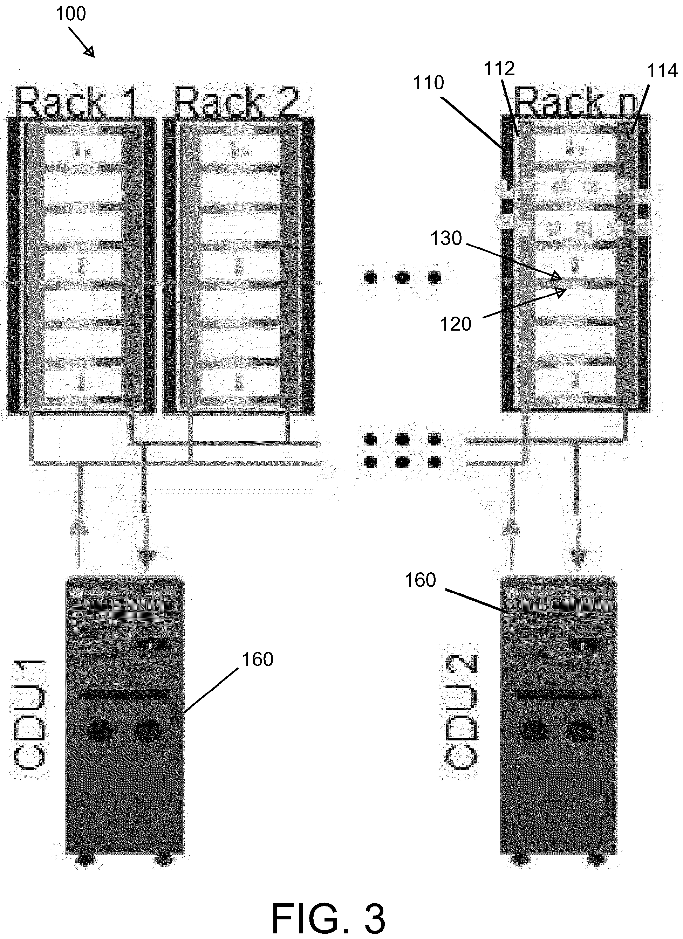

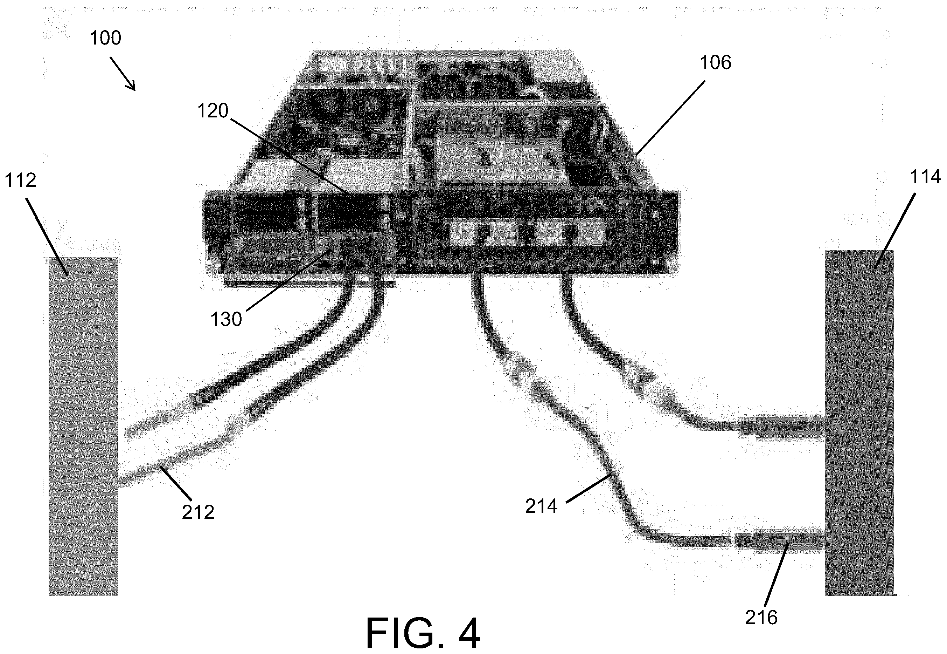

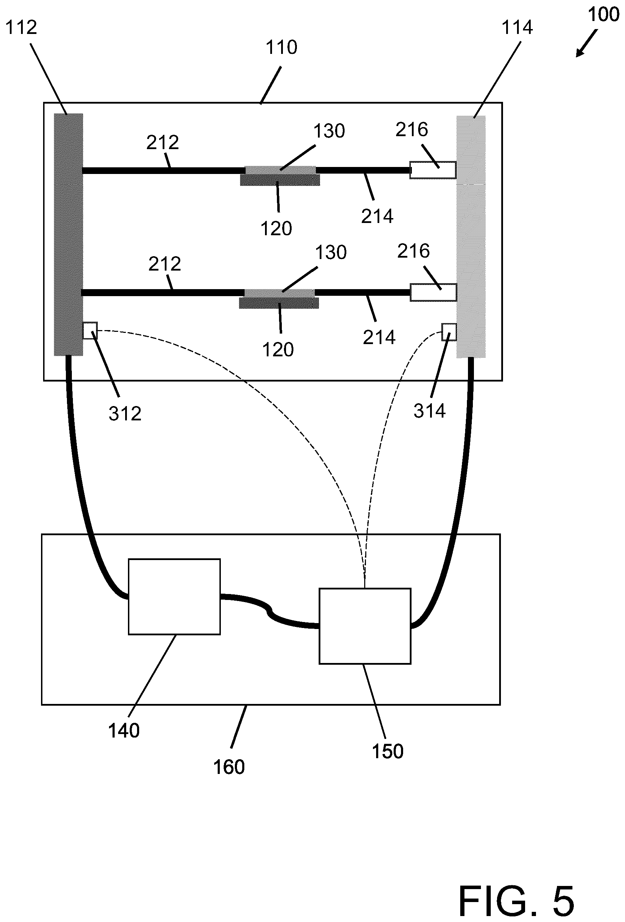

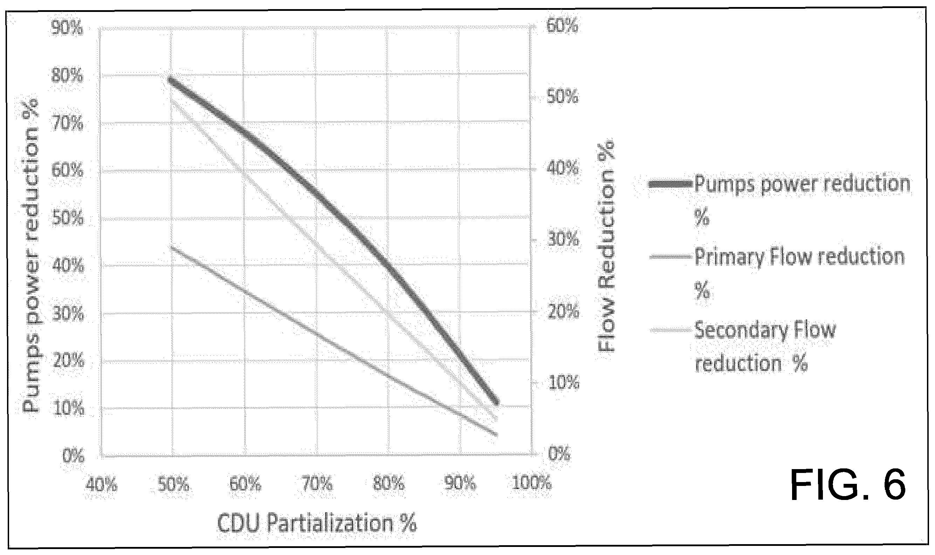

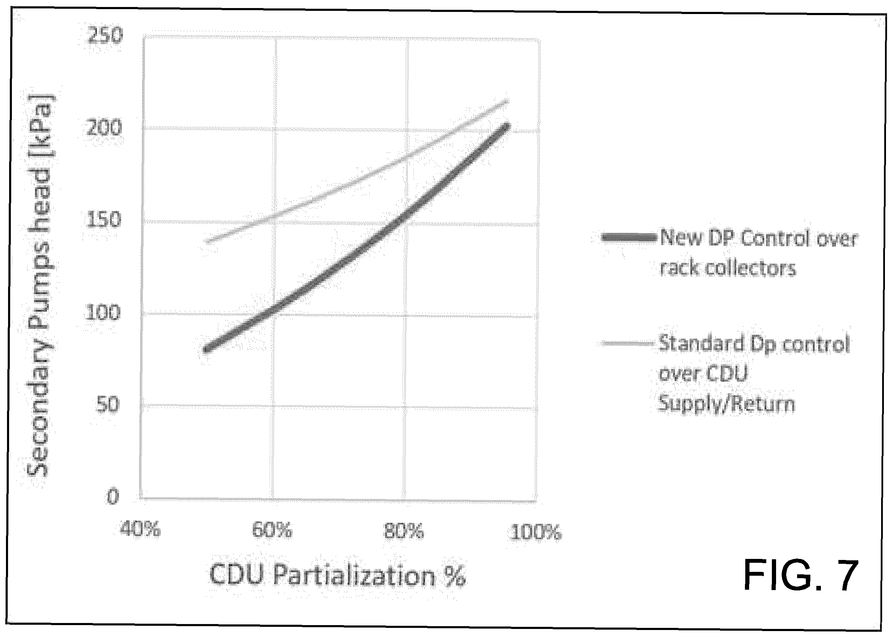

FIG. 1 is a simplified diagram of one of many embodiments of a cooling system according to the disclosure. FIG. 2 is a simplified diagram of another one of many embodiments of a cooling system according to the disclosure. FIG. 3 is a simplified diagram of yet another one of many embodiments of a cooling system according to the disclosure. FIG. 4 is a simplified diagram of a portion of one of many embodiments of a cooling system according to the disclosure. FIG. 5 is a schematic diagram of one of many embodiments of a cooling system according to the disclosure. FIG. 6 is a graph illustrating reduced flow and resulting power requirements according to one of many embodiments of a cooling system according to the disclosure. FIG. 7 is a graph illustrating reduced differential pressure requirements according to one of many embodiments of a cooling system according to the disclosure. FIGS. 1-7 are described in conjunction with one another.

In at least one embodiment, a cooling system 100 according to the disclosure can cool computer-related equipment 106 (e.g., servers or other information technology (IT) equipment) disposed in one or more enclosures 110, such as racks or cabinets utilized in data centers. For example, the cooling system 100 can include and/or can cool one or more processors 120 having one or more cold plates 130 thermally coupled thereto. In at least one embodiment, the cooling system 100 can cool the cold plates 130, and in turn cool the processors 120, by circulating a cooling fluid, such as a water or a water/glycol mixture, through the cold plates 130 and one or more heat exchangers 140 using one or more pumps 150 or other prime movers.

In at least one embodiment, the cooling system 100 can include one or more cold manifolds 112 for distributing a cooling fluid within one or more enclosures 110, one or more warm manifolds 114 for collecting or receiving the cooling fluid from within the enclosure(s) 110, one or more cold fluid lines 212 fluidically coupled between the cold manifold 112 and one or more cold plates 130 thermally coupled to one or more processors 120, one or more warm fluid lines 214 fluidically coupled between the warm manifold 114 and the cold plate 130, one or more flow regulators 216 for regulating flow through the warm fluid line 214 based at least in part on a temperature of the cooling fluid flowing through the warm fluid line 214, or a combination thereof. In at least one embodiment, the cold manifold 112 can receive the cooling fluid, such as a water/glycol mixture, from outside the enclosure 110, such as from one or more cooling distribution units (CDUs) 160, which can include, or be associated with, one or more pumps 150, one or more fans (e.g., within the CDU; not shown), one or more heat exchangers 140, or any combination thereof. In at least one embodiment, the CDU(s) 160 can include one or more internal temperature sensors and/or one or more internal pressure sensors (e.g., on the supply and return lines), any or all of which can be used to control the CDU(s) 160, pumps 150, fans, heat exchangers 140, or any combination thereof. In at least one embodiment, the temperature sensors and/or the pressure sensors of the CDU(s) 160 can be independent of other sensors, such as those described in more detail below.

In at least one embodiment, the cooling system 100 can include a single CDU 160 fluidically coupled to one or more cold plates 130 disposed in one or more enclosures 110 (see, e.g., FIG. 2). In at least one embodiment, the cooling system 100 can include two or more CDUs 160 fluidically coupled to one or more cold plates 130 disposed in one or more enclosures 110, and one or more of the CDUs 160 can be redundant for helping ensure failsafe operation of the system 100 (see, e.g., FIGS. 1 and 3).

In at least one embodiment, the flow regulator 216 can be fluidically coupled between the warm manifold 114 and the cold plate 130, such as in-line with the warm fluid line 214. In at least one embodiment, the flow regulator 216 can regulate flow through the first warm fluid line 214 based at least in part on the cooling fluid flowing through the warm fluid line 214 and/or the flow regulator 216. In at least one embodiment, the flow regulator 216 can regulate flow through the warm fluid line based at least in part on a temperature of the cooling fluid flowing through the warm fluid line 214 and/or the flow regulator 216.

In at least one embodiment, the flow regulator 216 can be or include an in-line temperature control valve offered by ThermOmegaTech^{®}, such as their TV/HAT-RA and/or TV/HAT-RA-LP models, or the like. In at least one embodiment, the flow regulator 216 can regulate flow independently of pressure. In at least one embodiment, the flow regulator 216 can regulate flow using an internal temperature sensor, such as a mechanical temperature sensing element that can operate independently from electrical power and/or electronic control. In at least one embodiment, the flow regulator 216 can maintain a non-zero minimum flow rate through the first warm fluid line, monitor the temperature of the processor 120, and increase flow through the cold plate 130 as the processor 120 begins to warm up and heat the cooling fluid flowing through the cold plate 130, the warm fluid line 214, the flow regulator 216, or any combination thereof.

In at least one embodiment, the system 100 can include one or more pumps 150 for pumping the cooling fluid through one or more portions of the system. In at least one embodiment, the pump 150 can pump cooling fluid to the cold manifold 112 from the warm manifold 114, such as through or via a heat exchanger 140 for cooling the cooling fluid downstream of the warm manifold 114. In at least one embodiment, the pump 150 can pump the cooling fluid to the cold manifold 112 from the warm manifold 114 and a predetermined differential pressure between the cold manifold 112 and the warm manifold 114 can be maintained, which can be or include any differential pressure required or desired in accordance with an implementation of the disclosure. In at least one embodiment, the system 100 can include a first pressure sensor 312 for monitoring a first pressure of the cold manifold 112 and a second pressure sensor 314 for monitoring a second pressure of the warm manifold 114. In at least one embodiment, the pump 150 can pump the cooling fluid to the cold manifold 112 from the warm manifold 114 based at least in part on a difference between the first pressure and the second pressure. In at least one embodiment, the pump 150 can pump the cooling fluid to the cold manifold 112 from the warm manifold 114 based on a difference between the first pressure and the second pressure independently of flow through the warm fluid line 214 and/or the temperature of the cooling fluid flowing through the warm fluid line 214.

In at least one embodiment, the system 100 can include a second cold fluid line 212 fluidically coupled between the cold manifold 112 and a second cold plate 130 thermally coupled to a second processor 120, a second warm fluid line 214 fluidically coupled between the warm manifold 114 and the second cold plate 130, a second flow regulator 216 for regulating flow through the second warm fluid line 214 based at least in part on a second temperature of the cooling fluid flowing through the second warm fluid line 214, or any combination thereof. In at least one embodiment, the second flow regulator 216 can be fluidically coupled between the warm manifold 114 and the second cold plate 130, such as in-line with the second warm fluid line 214. In at least one embodiment, the second flow regulator 216 can regulate flow through the second warm fluid line 214 based on the second temperature as sensed within the second flow regulator 216. In at least one embodiment, the second flow regulator 216 can be identical to and/or independent of the first flow regulator 216. In at least one embodiment, the second flow regulator 216 can regulate flow through the second warm fluid line 214 independently of the first flow regulator 216. In at least one embodiment, the pump 150 can maintain the predetermined differential pressure independently of the flow through the first warm fluid line 214 and/or independently of the flow through the second warm fluid line 214.

In at least one embodiment, the pump 150 and/or other components of the system 100 can maintain a target differential pressure (which can be predetermined by maximum heat load and/or other characteristics of the system 100) between the cold manifold 112 and the warm manifold 114. In at least one embodiment, the target differential pressure between the cold manifold 112 and the warm manifold 114 can be maintained regardless, or independently, of any or all individual pressures, temperatures, flow rates, or any combination thereof. For example, by holding the predetermined differential pressure (which can be or include a range of differential pressures) between the cold manifold 112 and the warm manifold 114, the pump 150 can ensure that each flow regulator 216 has sufficient flow available to adequately and independently cool each cold plate 130, and the associated processor 120, when the processor 120 is active and generating heat, while at the same time automatically reducing the work, and therefore power consumed, when one or more processors 120 are inactive.

In at least one embodiment, as each processor 120 goes inactive and the cooling fluid passing through the corresponding cold plate 130 cools, the associated flow regulator 216 can reduce flow through the associated cold plate 130, the associated warm fluid line 214, the associated cold fluid line 212, and itself. In at least one embodiment, the flow regulator 216 can refrain from completely choking off flow therethrough, and can allow some non-zero minimum flow to continuously pass there through for monitoring the temperature of the corresponding cold plate 130. In at least one embodiment, as each processor 120 goes active and the cooling fluid passing through the corresponding cold plate 130 heats up, the associated flow regulator 216 can increase flow through the associated cold plate 130, the associated warm fluid line 214, the associated cold fluid line 212, and itself. In at least one embodiment, the pump 150 can independently maintain the differential pressure between the cold manifold 112 and the warm manifold 114, while the individual flow regulators 216 independently control their own flow rates, thereby automatically accommodating the individual activity of the respective associated processors 120 while automatically reducing the work, and therefore power consumed, of the pump 150 as processors become inactive.

In at least one embodiment, the cooling system 100, such as for a data center equipment enclosure 110, can include a cold manifold 112 for receiving cold cooling fluid from outside the enclosure 110 and distributing the cooling fluid within the enclosure 110, a first pressure sensor 312 for monitoring a first pressure of the cold manifold 112, a warm manifold 114 for collecting or receiving the cooling fluid from within the enclosure 110, a second pressure sensor 314 for monitoring a second pressure of the warm manifold 114, a first cold fluid line 212 fluidically coupled between the cold manifold 112 and a first cold plate 130 thermally coupled to a first processor 120, a first warm fluid line 214 fluidically coupled between the warm manifold 114 and the first cold plate 130, a first flow regulator 216 for regulating flow through the first warm fluid line 114 and/or first cold plate 130 based on a first temperature of the cooling fluid flowing through the first flow regulator 216, a second cold fluid line 212 fluidically coupled between the cold manifold 112 and a second cold plate 130 thermally coupled to a second processor 120, a second warm fluid line 214 fluidically coupled between the warm manifold 114 and the second cold plate 130, a second flow regulator 216 for regulating flow through the second warm fluid line 214 and/or the second cold plate 130 based on a second temperature of the cooling fluid flowing through the second flow regulator 216, a pump 150 for pumping the cooling fluid to the cold manifold 112 from the warm manifold 114 based on a difference between the first pressure and the second pressure, or any combination thereof.

In at least one embodiment, the first pressure sensor 312 can be fluidically coupled to the cold manifold 112 and/or the second pressure sensor 314 can be fluidically coupled to the warm manifold 114. In at least one embodiment, the first flow regulator 216 can be fluidically coupled between the warm manifold 114 and the first cold plate 130, such as in-line with the first warm fluid line 214. In at least one embodiment, the second flow regulator 216 can be fluidically coupled between the warm manifold 114 and the second cold plate 130, such as in-line with the second warm fluid line 214. In at least one embodiment, the pump 150 can pump the cooling fluid to the cold manifold 112 from the warm manifold 114 through a heat exchanger 140. In at least one embodiment, the pump 150 can pump the cooling fluid to the cold manifold 112 from the warm manifold 114 independently of the flow through the first warm fluid line 214 and/or the flow through the second warm fluid line 214.

In at least one embodiment, the cooling system 100 can provide self-balancing across a plurality of cold plates 130. In at least one embodiment, the sensors 312, 314 and/or flow regulators 216 of the cooling system 100 can be disposed closer to individual cold plates 130 versus one or more sensors or flow regulators within the CDU(s) 160, and can react more precisely and responsively to individual processor 120 usage, and thus to cooling demand. In at least one embodiment, the cooling system 100 can control individual flow rates through each cold plate 130, and can provide the lowest possible, yet still effective, overall flow rate for a given implementation of the disclosure, in turn providing more efficient flow and/or reduced power consumption. In at least one embodiment, the cooling system 100 can maximize efficient heat recovery, and efficiency in general, in free cooling systems. In at least one embodiment, the cooling system 100 can benefit data center applications by providing more efficient flow and/or flow control, reduced power consumption, more efficient free cooling, more efficient heat recovery, more precise and responsive reactivity, or any combination thereof.

In at least one embodiment, the cooling system can be arranged for cooling computer-related equipment, such as equipment disposed in racks, cabinets, or other enclosures within data centers. In at least one embodiment, the cooling system can include a cold manifold for distributing a cooling fluid within the enclosure, a warm manifold for collecting or receiving the cooling fluid from within the enclosure, a cold fluid line fluidically coupled between the cold manifold and a cold plate thermally coupled to a processor, a warm fluid line fluidically coupled between the warm manifold and the cold plate, a flow regulator to regulate flow through the warm fluid line based at least in part on a temperature of the cooling fluid flowing through the warm fluid line, or a combination thereof. In at least one embodiment, the cold manifold can receive the cooling fluid, such as a water/glycol mixture, from outside the enclosure, such as from a cooling distribution unit (CDU) which can include, or be associated with, a pump and/or a heat exchanger.

In at least one embodiment, the flow regulator can be fluidically coupled between the warm manifold and the cold plate, such as in-line with the warm fluid line. In at least one embodiment, the flow regulator can regulate flow through the warm fluid line based at least in part on the cooling fluid flowing through the flow regulator. In at least one embodiment, the flow regulator can regulate flow through the warm fluid line based at least in part on a temperature of the cooling fluid flowing through the flow regulator.

In at least one embodiment, the flow regulator can regulate flow independently of pressure. In at least one embodiment, the flow regulator can regulate flow using an internal temperature sensor, such as a mechanical temperature sensing element that does not need electrical power and/or electronic control. In at least one embodiment, the flow regulator can maintain a non-zero minimum flow rate through the warm fluid line, monitor the temperature of the processor, and increase flow through the cold plate as the processor begins to warm up and heat the cooling fluid flowing through the cold plate, the warm fluid line, the flow regulator, or any combination thereof.

In at least one embodiment, the system can include a pump for pumping the cooling fluid to the cold manifold from the warm manifold, such as through a heat exchanger. In at least one embodiment, the pump can pump the cooling fluid to the cold manifold from the warm manifold maintaining a predetermined differential pressure between the cold manifold and the warm manifold. In at least one embodiment, the system can include a first pressure sensor for monitoring a first pressure of the cold manifold and a second pressure sensor for monitoring a second pressure of the warm manifold. In at least one embodiment, the pump can pump the cooling fluid to the cold manifold from the warm manifold based at least in part on a difference between the first pressure and the second pressure. In at least one embodiment, the pump can pump the cooling fluid to the cold manifold from the warm manifold based on a difference between the first pressure and the second pressure independently of flow through the warm fluid line and/or the temperature of the cooling fluid flowing through the warm fluid line.

In at least one embodiment, the system can include a second cold fluid line fluidically coupled between the cold manifold and a second cold plate thermally coupled to a second processor, a second warm fluid line fluidically coupled between the warm manifold and the second cold plate, a second flow regulator to regulate flow through the second warm fluid line based at least in part on a second temperature of the cooling fluid flowing through the second warm fluid line, or any combination thereof. In at least one embodiment, the second flow regulator can be fluidically coupled between the warm manifold and the second cold plate, such as in-line with the second warm fluid line. In at least one embodiment, the second flow regulator can regulate flow through the second warm fluid line based on the second temperature as sensed within the second flow regulator. In at least one embodiment, the second flow regulator can be identical to the first flow regulator. In at least one embodiment, the second flow regulator can regulate flow through the second warm fluid line independently of the first flow regulator. In at least one embodiment, the pump can maintain the predetermined differential pressure independently of the flow through the first warm fluid line and/or independently of the flow through the second warm fluid line.

In at least one embodiment, the cooling system, such as for a data center equipment enclosure, can include a cold manifold for receiving cold cooling fluid from outside the enclosure and distributing the cooling fluid within the enclosure, a first pressure sensor for monitoring a first pressure of the cold manifold, a warm manifold for collecting or receiving the cooling fluid from within the enclosure, a second pressure sensor for monitoring a second pressure of the warm manifold, a first cold fluid line fluidically coupled between the cold manifold and a first cold plate thermally coupled to a first processor, a first warm fluid line fluidically coupled between the warm manifold and the first cold plate, a first flow regulator to regulate flow through the first warm fluid line based on a first temperature of the cooling fluid flowing through the first flow regulator, a second cold fluid line fluidically coupled between the cold manifold and a second cold plate thermally coupled to a second processor, a second warm fluid line fluidically coupled between the warm manifold and the second cold plate, a second flow regulator to regulate flow through the second warm fluid line based on a second temperature of the cooling fluid flowing through the second flow regulator, a pump for pumping the cooling fluid to the cold manifold from the warm manifold based on a difference between the first pressure and the second pressure, or any combination thereof.

In at least one embodiment, the first pressure sensor can be fluidically coupled to the cold manifold and/or the second pressure sensor can be fluidically coupled to the warm manifold. In at least one embodiment, the first flow regulator can be fluidically coupled between the warm manifold and the first cold plate, such as in-line with the first warm fluid line. In at least one embodiment, the second flow regulator can be fluidically coupled between the warm manifold and the second cold plate, such as in-line with the second warm fluid line. In at least one embodiment, the pump can pump the cooling fluid to the cold manifold from the warm manifold through a heat exchanger.

Also disclosed in accordance with the above is a cooling system for a data center equipment enclosure, the system comprising:
a cold manifold configured to receive cold cooling fluid from outside the enclosure and distribute the cooling fluid within the enclosure;
a first pressure sensor fluidically coupled to the cold manifold and configured to monitor a first pressure of the cold manifold;
a warm manifold configured to receive the cooling fluid from within the enclosure;
a second pressure sensor fluidically coupled to the warm manifold and configured to monitor a second pressure of the warm manifold;
a first cold fluid line fluidically coupled between the cold manifold and a first cold plate thermally coupled to a first processor;
a first warm fluid line fluidically coupled between the warm manifold and the first cold plate;
a first flow regulator fluidically coupled between the warm manifold and the first cold plate, wherein the first flow regulator is fluidically coupled in-line with the first warm fluid line and configured to regulate flow through the first warm fluid line based on a first temperature of the cooling fluid flowing through the first flow regulator;
a second cold fluid line fluidically coupled between the cold manifold and a second cold plate thermally coupled to a second processor;
a second warm fluid line fluidically coupled between the warm manifold and the second cold plate;
a second flow regulator fluidically coupled between the warm manifold and the second cold plate, wherein the second flow regulator is fluidically coupled in-line with the second warm fluid line and configured to regulate flow through the second warm fluid line based on a second temperature of the cooling fluid flowing through the second flow regulator; and
a pump configured to pump the cooling fluid to the cold manifold from the warm manifold via a heat exchanger based on a difference between the first pressure and the second pressure.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The disclosure has been described in the context of preferred and other embodiments and not every embodiment of the disclosure has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope of the following claims.

## Claims

1. A cooling system for a data center equipment enclosure, the system comprising:
a cold manifold configured to receive cold cooling fluid from outside the enclosure and distribute the cooling fluid within the enclosure;
a warm manifold configured to receive the cooling fluid from within the enclosure;
a first cold fluid line configured to be fluidically coupled between the cold manifold and a first cold plate thermally coupled to a first processor;
a first warm fluid line configured to be fluidically coupled between the warm manifold and the first cold plate; and
a first flow regulator configured to regulate flow through the first warm fluid line based at least in part on a first temperature of the cooling fluid flowing through the first warm fluid line.

2. The cooling system of claim 1, wherein the first flow regulator is fluidically coupled between the warm manifold and the first cold plate.

3. The cooling system of claim 1 or 2, wherein the first flow regulator is fluidically coupled in-line with the first warm fluid line and configured to regulate flow through the first warm fluid line based at least in part on the cooling fluid flowing through the first flow regulator.

4. The cooling system of claim 1, 2 or 3, further comprising a pump configured to pump the cooling fluid to the cold manifold.

5. The cooling system of claim 4, further comprising a first pressure sensor configured to monitor a first pressure of the cold manifold and a second pressure sensor configured to monitor a second pressure of the warm manifold, and optionally wherein the pump is configured to pump the cooling fluid to the cold manifold from the warm manifold based at least in part on a difference between the first pressure and the second pressure, and further optionally wherein the pump is configured to pump the cooling fluid to the cold manifold from the warm manifold based on a difference between the first pressure and the second pressure independently of flow through the first warm fluid line.

6. The cooling system of claim 5, wherein the pump is configured to pump the cooling fluid to the cold manifold from the warm manifold based on a difference between the first pressure and the second pressure independently of the first temperature of the cooling fluid flowing through the first warm fluid line.

7. The cooling system of any preceding claim, further comprising:
a second cold fluid line configured to be fluidically coupled between the cold manifold and a second cold plate thermally coupled to a second processor;
a second warm fluid line configured to be fluidically coupled between the warm manifold and the second cold plate; and
a second flow regulator configured to regulate flow through the second warm fluid line based at least in part on a second temperature of the cooling fluid flowing through the second warm fluid line.

8. The cooling system of claim 7, wherein the second flow regulator is fluidically coupled between the warm manifold and the second cold plate and in-line with the second warm fluid line.

9. The cooling system of claim 7 or 8, wherein the second flow regulator is configured to regulate flow through the second warm fluid line based on the second temperature as sensed within the second flow regulator.

10. The cooling system of any of claims 7 to 9, wherein the second flow regulator is identical to the first flow regulator.

11. The cooling system of any of claims 7 to 10, wherein the second flow regulator is configured to regulate flow through the second warm fluid line independently of the first flow regulator.

12. The cooling system of any of claims 7 to 11, further comprising a pump configured to pump the cooling fluid to the cold manifold from the warm manifold; and wherein the cooling system is configured to maintain a predetermined differential pressure between the cold manifold and the warm manifold, and optionally wherein the cooling system is configured to maintain the predetermined differential pressure independently of the flow through the first warm fluid line and independently of the flow through the second warm fluid line.

13. The cooling system of any preceding claim, wherein the first flow regulator is configured to regulate flow independently of pressure.

14. The cooling system of any preceding claim, wherein the first flow regulator is configured to regulate flow based at least in part on an internal temperature sensor, and/or wherein the first flow regulator is configured to regulate flow based at least in part on a mechanical temperature sensing element independently of electrical power.

15. The cooling system of any preceding claim, wherein the first flow regulator is configured to maintain a non-zero minimum flow rate through the first warm fluid line.
